# EUROPEAN PATENT SPECIFICATION

(11) **EP 0 565 089 B1**
(45) Date of publication and mention of the grant of the patent: **03.07.1996**
(21) Application number: 93105782.2
(22) Date of filing: 07.04.1993
(51) Int. Cl.: H01J 37/317, H01J 37/30

(54) **Ion implanting apparatus**
Ionenimplantergerät
Appareil d'implantation ionique

(30) Priority: 10.04.1992 JP 90734/92
(43) Date of publication of application: 13.10.1993
(73) Proprietor: HITACHI, LTD., Chiyoda-ku, Tokyo 100 (JP)
(72) Inventor: Amemiya, Kensuke, Katsuta-shi (JP); Hakamata, Yoshimi, Hitachi-shi (JP); Tokiguchi, Katsumi, Mito-shi (JP); Sakudo, Noriyuki, Hitachi-shi (JP)
(74) Representative: Strehl Schübel-Hopf Groening & Partner

(56) References cited:
- EP-A- 0 163 745
- EP-A- 0 375 169
- NUCLEAR INSTRUMENTS & METHODS IN PHYSICS RESEARCH, SECTION - B: BEAM INTERACTIONS WITH MATERIALS AND ATOMS, vol. B55, no. 1-4, April 1991, AMSTERDAM, NL, pages 339-342, K. AMAMIYA et al.: 'Ion beam injection system for a variable energy RFQ accelerator.'
- NUCLEAR INSTRUMENTS & METHODS IN PHYSICS RESEARCH, SECTION - B: BEAM INTERACTIONS WITH MATERIALS AND ATOMS, vol. B21, no. 2-4, March 1987, AMSTERDAM, NL, pages 155-157, D. DIBITONTO et al.: 'Multi-Mev ion implantation accelerator system'

## Description

### BACKGROUND OF THE INVENTION

The present invention relates to an ion implanting unit utilizing a radio frequency linear ion accelerator, and relates more particularly to an ion implanting unit suitable for generating a high energy ion beam in a large current area.

An ion implanting unit utilizing a conventional radio frequency quadrupole (RFQ) ion accelerator is disclosed in the Japanese Patent Unexamined Publication No. JP-A-60-121656. This prior art technology has a characteristic that it can implant a high-energy ion of the range of several hundred keV to several MeV.

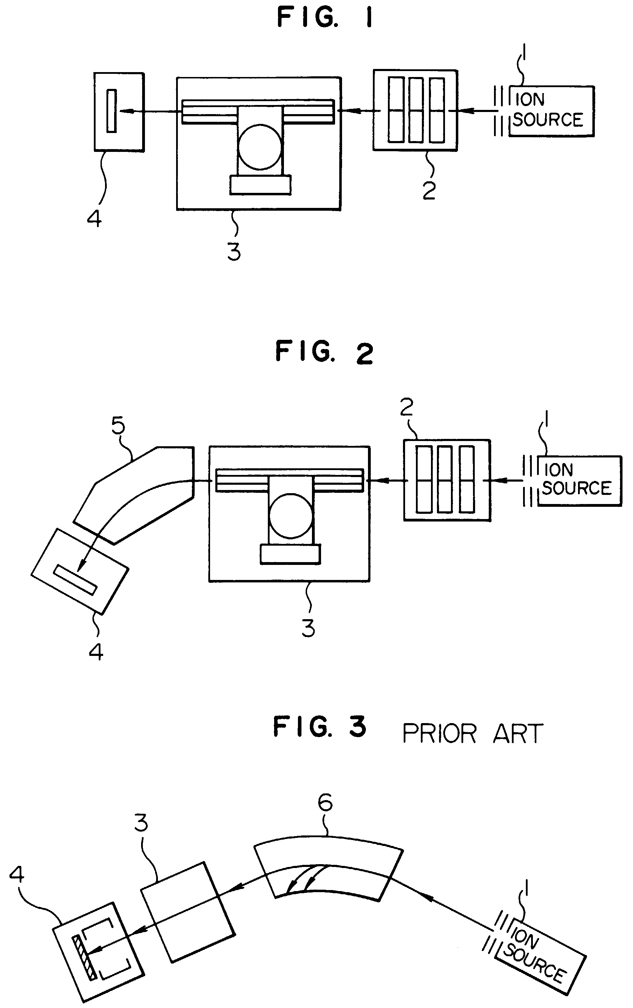

Fig. 3 is a block diagram for showing the configuration of the prior art technology.

As shown in this drawing, the conventional ion implanting unit has a basic structure which includes an ion source 1 for generating an ion to be implanted into a material to be processed in the vacuum, a mass spectrometer 6 for carrying out mass spectrometry of an ion that has been extracted from this ion source 1, an RFQ accelerator 3 for implanting an ion produced from this mass spectrometer 5 and accelerating at a radio frequency voltage, and an ion implanting chamber 4 for implanting an ion outputted from this RFQ accelerator 3 into the material to be processed.

A conventional example of the case where a quadrupole lens 2 is disposed between the mass spectrometer 6 and the RFQ accelerator 3 for the purpose of converging an ion beam that has been injected into the RFQ accelerator 3 is disclosed, for example, in the Nuclear Instruments and Methods in Physics Research B50, 1990, pp 478 - 480.

As described above, all of the prior art techniques employ a fan-shaped mass spectrometer 6 in order to select a necessary ion out of various kinds of ions which are included in the ion beam that has been extracted from the ion source 1.

On the other hand, in the case where the quadrupole lens 2 is disposed between the mass spectrometer 6 and the RFQ accelerator 3 for the purpose of converging the ion beam that has been incident to the RFQ accelerator 3, all of the prior art techniques employ an electrostatic quadrupole lens as shown by the Nuclear Instruments and Methods in Physics Research B37/38, 1989, pp 94 - 97.

As described above, according to the prior art techniques, the use of the RFQ accelerator makes it possible to implant high-energy ions but the ion beam that has been extracted from the ion source 1 is not utilized to the maximum extent, so that a current value is reduced to a half or below during the transportation of the beam from the ion source 1 to the ion implanting chamber 4, with a result that a large current can not be obtained. The above problem occurs for the following reasons. In the example of Fig.3, the fan-type mass spectrometer 6 is used to carry out mass spectrometry of the ion beam that has been extracted from the ion source 1. The fan-type mass spectrometer 6, however, provides low transmissivity because it utilizes a work of a weak convergent lens. Further, when the electrostatic quadrupole lens has been disposed between the mass spectrometer 6 and the RFQ accelerator 3, the electrostatic quadrupole lens makes the electron taken into the beam to be detached and, therefore, it is not possible to restrict the divergence of the beam due to space charge, with a result that the ion beam can not be sufficiently converged to the incident opening of the RFQ accelerator 3.

### SUMMARY OF THE INVENTION

It is an object of the present invention to provide an apparatus for generating a high-energy ion beam in a large current area.

The above-described object can be achieved by an apparatus which includes an ion source for generating a beam including various kinds of ion, a multipole lens for carrying out mass spectrometry of a beam including various kinds of ion from the ion source and converging the beam, a radio frequency accelerator for accelerating an ion beam from the multipole lens to a predetermined energy level by a radio frequency field and an ion implanting chamber for implanting an ion beam from the radio frequency accelerator into a material to be processed.

The above-described object can be achieved by using, in addition to the features of Claim 1, a magnetic field quadrupole lens as the multipole lens.

The above-described object can be achieved by using, in addition to the features of Claim 2, the magnetic field quadrupole lens by at least three stages.

The above-described object can be achieved by using, in addition to the features of Claim 1, a quadrupole particle accelerator which has mutually facing planes of the quadrupole electrode formed in a wave shape, as the radio frequency accelerator.

The above-described object can be achieved by, in addition to the features of Claim 1, having disposed a radio frequency resonance circuit of the radio frequency accelerator at the outside of an accelerating tube.

The above-described object can be achieved by, in addition to the features of Claim 1, having disposed between the radio frequency accelerator and the ion implanting chamber a beam deflector of which angle for implanting ions into the material to be processed is variable.

The above-described object can be achieved by using, in addition to the features of Claim 6, a magnetic field spectrometer for the beam deflector.

In order to achieve the above-described object, the present invention utilizes a mass spectrometry function and a convergence function of the multipole lens.

Among the multipole lenses, the quadrupole lens is used to converge a charged particle beam by an electrostatic field or a magnetic field and the quadrupole lens also has a function of selecting necessary ions. Convergence characteristics of a beam are determined by mass, velocity and the number of electric charges of a particle, as is the case with the normal fan-type mass spectrometer. When a desired ion has been converged, the rest of the ions are diverged through entirely different orbits. Thus, the quadrupole lens also has a mass spectrometry function similar to that of the fan-type mass spectrometer.

The quadrupole lens can carry out mass spectrometry of a beam in a short direction by proceeding the beam in a straight direction, because the quadrupole lens uses a strong convergent lens. Thus, the quadrupole lens can pass the beam with the transmissivity of almost 100 %, which is at least two times of the transmissivity of the conventional fan-type mass spectrometer that utilizes a weak convergent lens. Accordingly, it is possible to provide a simple and compact unit which has both the mass spectrometry function and lens convergence function by keeping the beam current value at a level of at least two times of the conventional mass spectrometer.

While the fan-type mass spectrometer has not been able to have a large take-out area of the ion source because of its small allowance area (acceptance) of beam passage, the use of the quadrupole lens makes it possible to have a larger ion extraction area of the ion source and makes it possible to improve the current value of the beam incident to the RFQ accelerator by about five times to a level in the order of several ten milliamperes.

As compared with the electrostatic type quadrupole lens, the magnetic field type quadrupole lens can hardly make the electron which has been taken into the beam to be deviated. Therefore, the divergence of the beam due to the space charge can be restricted to the largest extent, so that a large current ion beam in the order of several ten milliamperes can be sufficiently converged to the incident opening of the RFQ. This is explained as follows. While the force acting on the charged particle of the electrostatic field is determined by qE where E represents the electric field strength and q represents the electric charge of the particle, the force acted on the charged particle of the magnetic field (magnetic flux density : B) is determined by qvB in proportion to the velocity v, so that a low-speed electron taken into the beam is not deviated from the beam even if it was influenced by an magnetic field.

A quadrupole lens of at least three stages has a larger degree of freedom than a quadrupole lens of two stages or less and can converge a beam at any distance in any magnification of an image at the same magnification for both horizontal and vertical directions. Therefore, even if the size of the incident opening of the RFQ has changed, an optimum condition for an incident beam can be obtained without changing the distance from the lens to the RFQ accelerator. Thus, it is possible to generate a high-energy ion beam of a large current area in the order of several ten milliamperes with various kinds of ion.

Among the radio frequency accelerators, the RFQ accelerator has the best acceleration efficiency per unit length and the RFQ accelerator having a radio frequency resonance circuit disposed outside of the accelerating tube can make the outgoing energy from the accelerator to be variable. Accordingly, with the above-described arrangement, it is possible to make the whole unit size to be compact and it is also possible to generate a high-energy ion beam with any desired level of energy from several hundred keV to several MeV in a large current area in the order of milliamperes to several ten milliamperes based on various kids of ion.

### BRIEF DESCRIPTION OF THE DRAWINGS

Fig. 1 is a block diagram for showing the configuration of the first embodiment of the present invention.

Fig. 2 is a block diagram for showing the configuration of the second embodiment of the present invention.

Fig. 3 is a block diagram for showing the configuration of the prior art technique.

### DESCRIPTION OF THE PREFERRED EMBODIMENTS

One embodiment of the present invention will be explained below with reference to a drawing.

### A First Embodiment

Fig. 1 is a block diagram for showing the configuration of the first embodiment of the present invention.

As shown in the drawing, the present unit is an ion implanting unit, having a quadrupole lens 2 disposed between an ion source 1 and an RFQ accelerator 3, for generating a high-energy ion beam in a large current area in the order of several ten milliamperes.

The ion source 1 is a multi-charged ion source of microwave discharge type, which has a multipole magnetic field formed with an octupole permanent magnet disposed in the outer periphery of a cylindrical plasma chamber, and which also has a mirror field formed by solenoid coils in the axial direction. Based on a discharging of a microwave in the magnetic field, a high-density ion beam of 30 mA/cm² or above can be extracted from an extraction electrode. An argon ion beam of 30 mA was able to be taken out from a take-out hole of a maximum diameter of 10 mm.

The quadrupole lens 2 is a three-staged magnetic quadrupole lens which uses three single lenses with a lens length of 110 mm. A maximum exciting current is 70 A, and an ion beam of monovalent to trivalent argon of ten and several milliamperes can be converged to the RFQ incident hole having the diameter of 10 mm. Further, if the take-out area of the ion source is expanded, a current value of several ten milliamperes can be secured.

The RFQ accelerator 3 is an RFQ accelerator of external resonance circuit type which has a radio frequency resonance circuit disposed at the outside of the accelerating tube, and uses an RFQ electrode having a total length of 2.3 m. The resonance circuit is structured by a capacitance variable capacitor and an inductance variable coil. By forming a circuit which oscillates in the region of 10 MHz to 30 MHz, it is possible to obtain a high-energy beam of the region from 0.5 MeV to 4 MeV. Maximum 50 kW is necessary as radio frequency power to be inputted to the RFQ accelerator 3.

The implanting chamber 4 can have tens of pieces of wafer loaded on a rotating disk when an ion is to be implanted into a silicon semiconductor wafer, and in the case of processing a single article such as an industrial material, a target holder having a rotation axis of at least three axes can be installed in the implanting chamber. With this arrangement, a high-energy implanting of ions into a semiconductor wafer, an industrial material, etc. can be achieved at a high throughput level similar to the level achieved by the conventional ion implanting unit having a large current and middle energy of 200 keV or below.

### A Second Embodiment

Fig. 2 is a block diagram for showing the configuration of a second embodiment of the present invention.

The present embodiment is an ion implanting unit for implanting an ion beam into a material to be processed after the ion beam has been deflected. The ion implanting unit of the present embodiment has a quadrupole lens 2 disposed between an ion source 1 and an RFQ accelerator 3 in the same manner as the first embodiment, to produce a high-energy ion beam in a large current area in the order of several ten milliamperes and then to deflect an accelerated beam by a deflector 5, for implanting the deflected ion beam into the material to be processed. With this structure, it is possible to control the angle of implanting an ion beam into the material to be processed and also to process a large-area material to be processed by scanning the ion beam. The deflector 5 can also work as a velocity filter for removing a fine quantity low-energy beam included in the accelerated beam, to thereby improve the purity of the beam to be implanted into the material to be processed.

In the first and second embodiments, materials that can be processed and installed in the ion implanting chamber 4 include semiconductor materials such as silicon, arsenic gallium and phosphorus indium, various metal materials such as steel and stainless steel, ceramic materials such as aluminum and boron nitride, and other materials such as glass materials, organic materials, etc. Further, the materials to be processed may have various shapes such as a plane shape of a semiconductor wafer and complex shapes such as for gears and engine parts, etc. so that these embodiments can be applied to a wide range of surface processing.

As described above, according to the present embodiments, it is possible to utilize an ion beam extracted from the ion source to the maximum extent and to restrict a reduction of a current value during a transportation of the beam to the minimum. Accordingly, it is possible to generate a high-energy ion beam of any energy level ranging from several hundred keV to several MeV in a large current area in the order of tens of milliamperes which is about five times of the conventional level.

Further, since mass spectrometry and convergence are carried out at the same time in a linear beam, it is possible to have a unit in a simple linear structure and also in a more compact size in total than that of the conventional unit.

Further, it is possible to provide an ion processing unit which can not only utilize an ion beam in the order of MeV in the production process of a semiconductor unit but also reduce time required for improving the quality of the surface layer of the materials such as metals and ceramics, so that the ion processing unit is suitable for a mass production of these materials.

According to the present invention, a multipole lens is disposed between the ion source and the radio frequency accelerator, so that the multipole lens can converge the ion beam from the ion source and also can carry out mass spectrometry of the beam and then increase a beam current value of the beam incident to the RFQ accelerator and the RFQ accelerator can accelerate the ion beam and generate a high-energy ion beam in a large current area.

## Claims

1. An ion implanting unit, comprising an ion source (1) for generating a beam including various kinds of ions, a multipole lens (2) for carrying out mass spectrometry of said beam while converging the beam, a radio frequency accelerator (3) for accelerating the beam from said lens (2) to a predetermined energy level with a radio frequency field, and an ion implanting chamber (4) for implanting ions of the beam from said radio frequency accelerator (3) into a material to be processed.

2. The ion implanting unit of claim 1, wherein said lens is a magnetic field type quadrupole lens (2).

3. The ion implanting unit of claim 2, wherein said lens (2) has at least three stages.

4. The ion implanting unit of any one of claims 1 to 3, wherein said radio frequency accelerator is a quadrupole particle accelerator (3) including quadrupole electrodes having mutually facing planes formed in a wave shape.

5. The ion implanting unit of any one of claims 1 to 4, wherein said radio frequency accelerator (3) includes an accelerating tube and a radio frequency resonance circuit disposed outside said accelerating tube.

6. The ion implanting unit of any one of claims 1 to 5, further comprising a beam deflector (5) disposed between said radio frequency accelerator (3) and said ion implanting chamber (4) and being adapted to vary the angle at which ions are implanted into said material.

7. The ion implanting unit of claim 6, wherein said beam deflector (5) is a magnetic analyser.

## Patentansprüche

1. Ionenimplantiereinheit, umfassend eine Ionenquelle (1) zur Erzeugung eines verschiedene Ionenarten enthaltenden Strahls, eine Mehrpol-Linse (2), die den Strahl zur Konvergenz bringt und gleichzeitig einer Massenspektrometrie unterwirft, einen Hochfrequenz-Beschleuniger (3) zum Beschleunigen des Strahls von der Linse (2) auf einen vorgegebenen Energiepegel mittels einem Hochfrequenzfeldes, und eine Ionenimplantierkammer (4) zum Implantieren von Ionen des Strahls aus dem Hochfrequenz-Beschleuniger (3) in ein zu bearbeitendes Material.

2. Ionenimplantiereinheit nach Anspruch 1, wobei die Linse eine Magnetfeld-Vierpollinse (2) ist.

3. Ionenimplantiereinheit nach Anspruch 2, wobei die Linse (2) mindestens drei Stufen aufweist.

4. Ionenimplantiereinheit nach einem der Ansprüche 1 bis 3, wobei der Hochfrequenz-Beschleuniger ein Vierpol-Teilchenbeschleuniger (3) ist, der Vierpol-Elektroden mit einander zugewandten Ebenen in Wellenform aufweist.

5. Ionenimplantiereinheit nach einem der Ansprüche 1 bis 4, wobei der Hochfrequenz-Beschleuniger (3) eine Beschleunigungsröhre und einen außerhalb dieser angeordneten Hochfrequenz-Resonanzkreis aufweist.

6. Ionenimplantiereinheit nach einem der Ansprüche 1 bis 5, mit einem zwischen dem Hochfrequenz-Beschleuniger (3) und der Ionenimplantierkammer (4) angeordneten Strahlablenker (5) zur Änderung des Winkels, unter dem Ionen in das Material implantiert werden.

7. Ionenimplantiereinheit nach Anspruch 6, wobei der Strahlablenker (5) ein magnetischer Analysator ist.

## Revendications

1. Dispositif d'implantation ionique, comprenant une source (1) d'ions afin de générer un faisceau comportant divers types d'ions, une lentille multipolaire (2) pour effectuer une spectrométrie de masse dudit faisceau tout en faisant converger le faisceau, un accélérateur (3) haute fréquence pour faire subir une accélération au faisceau issu de ladite lentille (2) jusqu'à un niveau d'énergie prédéterminé avec un champ haute fréquence, et une chambre (4) d'implantation ionique pour implanter, dans une matière à traiter, des ions du faisceau issu dudit accélérateur (3) haute fréquence.

2. Dispositif d'implantation ionique selon la revendication 1, dans lequel ladite lentille est une lentille quadripolaire (2) du type à champ magnétique.

3. Dispositif d'implantation ionique selon la revendication 2, dans lequel ladite lentille (2) a au moins trois étages.

4. Dispositif d'implantation ionique selon l'une quelconque des revendications 1 à 3, dans lequel ledit accélérateur haute fréquence est un accélérateur quadripolaire (3) de particules comportant des électrodes quadripolaires ayant des plans qui se font face sous la forme d'une vague.

5. Dispositif d'implantation ionique selon l'une quelconque des revendications 1 à 4, dans lequel ledit accélérateur (3) haute fréquence comporte un tube d'accélération et un circuit à résonance haute fréquence disposé à l'extérieur dudit tube d'accélération.

6. Dispositif d'implantation ionique selon l'une quelconque des revendications 1 à 5, comportant en outre un déflecteur (5) de faisceau disposé entre ledit accélerateur (3) haute fréquence et ladite chambre (4) d'implantation ionique permettant de modifier l'angle suivant lequel les ions sont implantés dans ladite matière.

7. Dispositif d'implantation ionique selon la revendication 6, dans lequel ledit déflecteur (5) de faisceau est un analyseur magnétique.
